(19) Europäisches Patentamt

European Patent Office

Office européen des brevets

(11) **EP 1 001 473 A2**

(12) **EUROPEAN PATENT APPLICATION**

(43) Date of publication:
**17.05.2000 Bulletin 2000/20**

(51) Int. Cl.⁷: **H01L 39/02**

(21) Application number: **99122647.3**

(22) Date of filing: **13.11.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **16.11.1998 JP 32512198**

(71) Applicant:
**INTERNATIONAL SUPERCONDUCTIVITY TECHNOLOGY CENTER**
**Tokyo 105-0004 (JP)**

(72) Inventors:
• **Matsuoka, Satoshi,**
  **Superconductivity Res., Lab.**
  **Tokyo 135-0062 (JP)**

• **Maeda, Junya,**
  **Superconductivity Res., Lab.**
  **Tokyo 135-0062 (JP)**
• **Imagawa, Yuichi,**
  **Superconductivity Res., Lab.**
  **Tokyo 135-0062 (JP)**
• **Shiohara, Yuh,**
  **Superconductivity Res., Lab.**
  **Tokyo 135-0062 (JP)**
• **Tanaka, Shoji,**
  **Superconductivity Res., Lab.**
  **Tokyo 135-0062 (JP)**

(74) Representative:
**von Kreisler, Alek, Dipl.-Chem. et al**
**Patentanwälte,**
**von Kreisler-Selting-Werner,**
**Bahnhofsvorplatz 1 (Deichmannhaus)**
**50667 Köln (DE)**

(54) **Superconducting system**

(57)     A superconducting system 1 comprising an electronic device 2 and a thin fiber 3 to electrically connect the electronic device 2 to an external device. By the use of the superconducting system 1, the heat load due to a lead wire can be inhibited, which in turn results in the reduction of the load on a freezer used to cool the electronic device or reduction of the amount of evaporated solvent. It is also capable of coping with the multi-channeling of an electronic device in the future.

**F i g .  1**

EP 1 001 473 A2

Printed by Xerox (UK) Business Services
2.16.7 (HRS)/3.6

## Description

### TECHNICAL FIELD OF THE INVENTION

The present invention relates to a superconducting system. More particularly, the present invention relates to a superconducting system comprising an electronic device using a superconductor.

### BACKGROUND OF THE INVENTION

Superconducting oxide has been used for various electronic devices. Examples of the electronic device using such superconducting oxide (hereinafter also simply referred to as an electronic device) include a SQUID system to detect quantized flux, a superconducting computer system utilizing a Josephson element (logical element comprising an ultra-thin insulating layer sandwiched between superconductors) and the like. These electronic devices are cooled to not more than an absolute temperature of about 60K (about -210°C) to make superconducting oxide reach a superconducting state and to reduce influence of noise and the like. This cooling is afforded by the use of a cooling solvent such as liquid helium or in an ultra-low temperature freezer.

These electronic devices are associated with the problems of evaporation of cooling solvent due to a heat load, and poor operation efficiency of a freezer. The heat load is mainly caused by an invasion heat that travels from outside through a lead wire which supplies a current to an electronic device, and Joule's heat generated when the current is flown through the lead wire. Therefore, both the invasion heat and Joule's heat should be reduced simultaneously.

In the case of a metal material, such as a copper wire and a copper alloy wire, which has been conventionally used for supplying a current to an electronic device, however, a free electron that transmits electricity also transmits heat. When Joule's heat is suppressed by increasing the cross sectional area to improve the electric conduction level, the degree of heat conduction grows to increase the invasion heat. In other words, the use of a lead wire of such a metal material confronts a tremendous difficulty in achieving both the reduction of invasion heat and the reduction of Joule's heat.

In addition, an electronic device increasingly has more channels. For example, MEG (magnetoencephalogram) consisting of SQUID elements using superconducting oxide must measure minimum regions, which will necessitate several dozen to several hundreds of channels in the future, each of which channels requiring a current lead to supply a current. In this case, the problems due to the heat load are considered to grow.

It is therefore an object of the present invention to provide a superconducting system that suppresses the heat load on a lead wire.

### SUMMARY OF THE INVENTION

The superconducting system of the present invention electrically connects an electronic device using a superconductor and comprises a thin fiber made of superconducting oxide, which connects the electronic device to an external device.

As the thin fiber, a single crystal fiber made of a superconducting oxide by unidirectional solidification can be used. The thin fiber preferably has a diameter of not more than 500 µm, particularly 50 µm - 300 µm. As the thin fiber, one having a superconducting oxide film formed on the surface of a non-superconducting fiber can be used. This superconducting oxide preferably has a film thickness of not more than 100 µm, particularly 10 µm - 50 µm. The superconducting oxide is preferably a rare earth superconducting oxide. Examples of the electronic devices using a superconducting oxide include a SQUID system to detect quantized flux, a computer system utilizing a Josephson element and the like. The superconducting system of the present invention can further comprise a switchboard and a normal conductor fiber.

### BRIEF DESCRIPTION OF THE DRAWINGS

Fig. 1 shows one embodiment of the superconducting system of the present invention, in which the system is summarized. In Fig. 1, 1 is a superconducting system, 2 is an electronic device and 3 is a thin fiber.

Fig. 2 shows an apparatus to prepare a thin fiber to be used in the present invention by unidirectional solidification.

Fig. 3 shows one embodiment of the thin fiber to be used in the present invention, which was prepared by the apparatus shown in Fig. 2.

Fig. 4 shows one embodiment of the thin fiber to be used in the present invention, which was prepared by LPE method.

### DETAILED DESCRIPTION OF THE INVENTION

The present invention is explained in detail in the following by referring to the drawings.

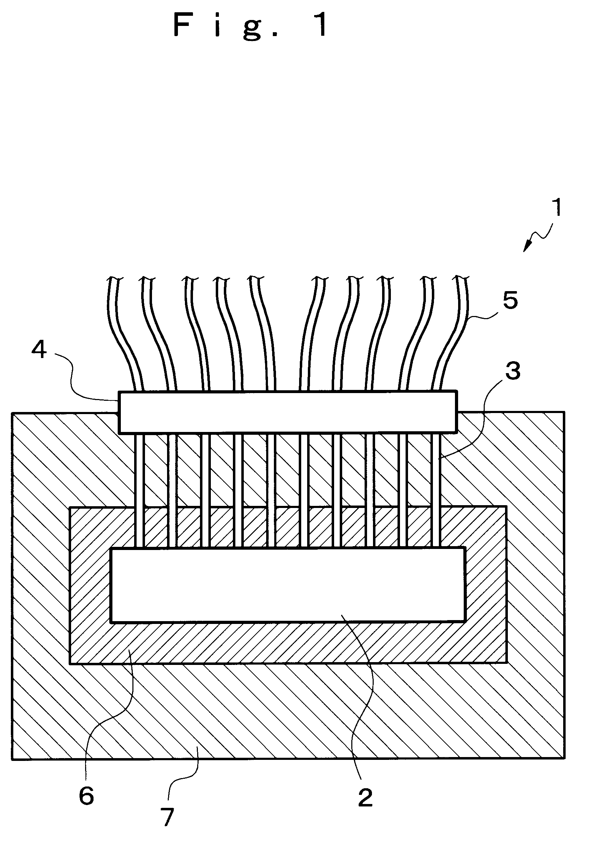

As in the embodiment shown in Fig. 1, the superconducting system 1 of the present invention comprises an electronic device 2 using a superconductor and a thin fiber 3. The thin fiber 3 is made of a superconducting oxide. The thin fiber 3 electrically connects the electronic device 2 and an external device (not shown).

In the embodiment shown in Fig. 1, the electronic device 2 has plural channels which are connected to plural thin fibers. The thin fiber 3 is electrically connected to an external device via a switchboard 4 and then a normal conductor fiber 5. The normal conductor fiber 5 is made of a normal conductor such as copper, and is directly connected to an external device. The switchboard 4 electrically connects the thin fiber 3 and the normal conductor fiber 5. The switchboard 4 may have a function of on/off switching the circuit.

The electronic device 2 is cooled with liquid helium 6. The liquid helium 6 and thin fiber 3 are cooled with liquid nitrogen 7.

In the superconducting system 1 of the present invention, the thin fiber 3 made of superconducting oxide is used as a connection lead between the electronic device 2 and an external device. A superconducting oxide forming the thin fiber 3 shows heat conduction performance as that of ceramic, which is characteristically strikingly smaller than that of a metal. In terms of electric conduction, unlike a metal which conducts by the transmission of a free electron, since Cooper pair is involved in the case of superconducting oxide, a flow of a current up to a certain level (critical current value) does not cause degradation of superconductivity in the absence of resistance. In other words, a flow of a current up to a certain level does not cause generation of Joule's heat.

That is, in the superconducting system 1 of the present invention, the use of the thin fiber 3 made of superconducting oxide as a current lead wire for connection with an external device can realize both reduction of invasion heat and reduction of Joule's heat, thereby suppressing the heat load in the electronic device 2.

Examples of the superconducting oxide forming the thin fiber in the present invention include RE123 superconductor (rare earth superconducting oxide), Bi superconducting oxide and Tl superconducting oxide.

Specific examples of RE123 superconductor include $Y_1Ba_2Cu_3O_X$, $Yb_1Ba_2Cu_3O_X$ $Dy_1Ba_2Cu_3O_X$, $Gd_1Ba_2Cu_3O_X$, $Sm_1Ba_2Cu_3O_X$, $Nd_1Ba_2Cu_3O_X$, and $(Yb,Y)_1Ba_2Cu_3O_X$, $(Nd,Y)_1Ba_2Cu_3O_X$ and $(Nd,Sm,Y)_1Ba_2Cu_3O_X$, the last three comprising rare earth element (mixed crystal).

Examples of Bi superconducting oxide include $Bi_2Sr_2Ca_1Cu_2O_X$ and $Bi_2Sr_2Ca_2Cu_3O_X$. Examples of Tl superconducting oxide include $Tl_2Sr_2Ca_1Cu_2O_X$, $Tl_2Sr_2Ca_2Cu_3O_X$, $Tl_1Sr_2Ca_2Cu_3O_X$ and the like.

As used in the present invention, the thin fiber made of superconducting oxide means that the thin fiber is made of superconducting oxide alone, or it is made of both superconducting oxide and a non-superconductor.

The amount of oxygen in the above-mentioned examples, wherein the superconducting oxide is an $O_2$-treated conductor, is $6.5 \leqq X \leqq 8.0$ for RE123 superconductor (inclusive of mixed crystal), $7.5 \leqq X \leqq 8.5$ for $Bi_2Sr_2Ca_1Cu_2O_X$, $9.5 \leqq X \leqq 10.5$ for $Bi_2Sr_2Ca_2Cu_3O_X$, $7.5 \leqq X \leqq 8.5$ for $Tl_2Sr_2Ca_1Cu_2O_X$, $9.5 \leqq X \leqq 10.5$ for $Tl_2Sr_2Ca_2Cu_3O_X$ and $5.5 \leqq X \leqq 6.5$ for $Tl_1Sr_2Ca_2Cu_3O_X$.

The production method of the thin fiber of the present invention is not particularly limited and may be a conventional method for producing superconducting oxide. However, when the superconducting oxide is an RE123 superconductor such as YBCO, and the crystal azimuth plane drastically varies in the crystal intergranule, the superconducting current does not flow beyond that point. In this case, a single crystal production method or a production method that orients crystals should be used.

As the production method of single crystal, unidirectional solidification (a kind of zone melt method) is preferable, wherein superconducting oxide or a precursor thereof is partially melted and then solidified. For orientation of crystals, LPE method (liquid phase epitaxy) is preferable. The unidirectional solidification and LPE are explained in the following.

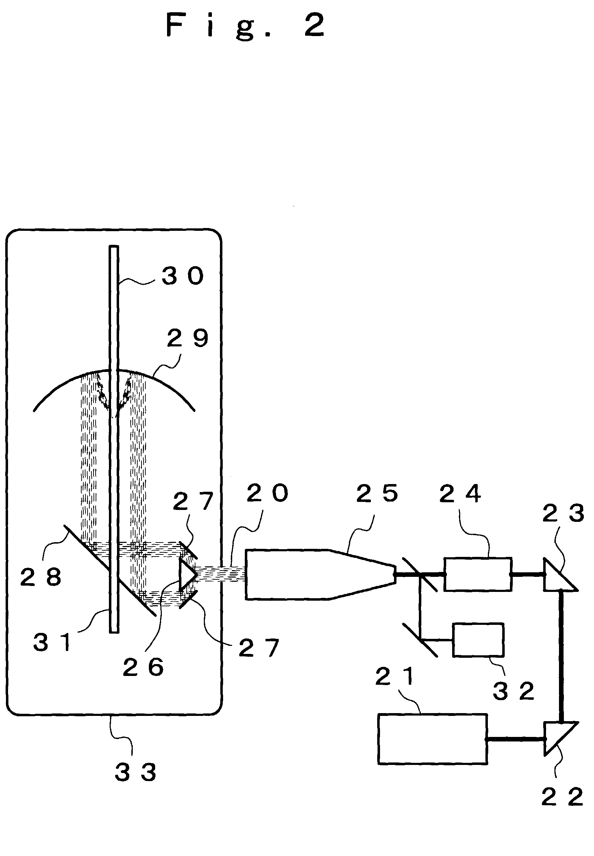

Fig. 2 shows an apparatus for making the thin fiber to be used in the present invention by unidirectional solidification. In the embodiment shown in Fig. 2, the precursor to be the superconducting oxide is heated with a laser beam. A laser beam 20 irradiated from a laser beam oscillator 21 is introduced into a chamber 33 via mirrors (22, 23), attenuation apparatus 24 and a beam diameter varying lens 25. The laser beam 20 introduced into the chamber 33 is reflected by mirror 26 to mirror 27, 28 and finally by mirror 29 to partially heat a sample 30 (precursor to be the superconducting oxide) and melts the sample in a band. By 31 is meant a formed thin fiber and by 32 a laser beam oscillator to irradiate a laser beam for adjusting focus. In the chamber 33, the partial oxygen pressure is maintained. Thus, an Sm-Ba-Cu superconducting oxide and an Nd-Ba-Cu superconducting oxide can be also prepared, that do not show superior superconducting properties unless melt-solidified in a low oxygen atmosphere.

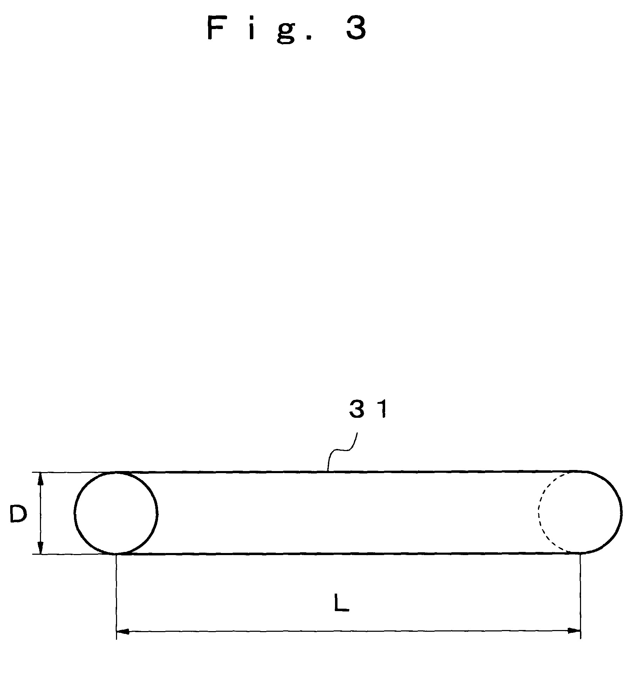

Fig. 3 shows one embodiment of the thin fiber to be used in the present invention, which was prepared by the apparatus shown in Fig. 2. The thin fiber 31 shown in Fig. 3 is a pseudo-single crystal superconducting oxide, which comprises a high temperature stable RE211 phase and RE123 phase, or a high temperature stable RE422 phase and RE123 phase. The single crystal fiber as referred to in the present invention includes both complete single crystals and pseudo-single crystals of this kind.

In general, for a superior single crystal to be obtained by unidirectional solidification, the ratio of temperature gradient G to transfer rate R, G/R ratio, at the interface between molten region and solidified region (molten-solidification interface) is preferably made greater. For example, too fast a growth (greater R at the interface) when the temperature gradient is small makes the G/R ratio small, which in turn results in polycrystallization or failure to form crystals.

Therefore, to obtain superior crystals at high rate, it is preferable that the temperature gradient at the molten-solidification interface be set greater.

As shown in Fig. 2 in the present invention therefore, a laser beam is used to make the temperature gradient greater. For example, in the case of conventional unidirectional solidification utilizing heating method by electric resistance, the temperature gradient at the solidification-molten interface is limited to approximately 40°C/mm. However, unidirectional solidification using a laser beam permits a temperature gradient of not less than 300°C/mm. Preferable temperature gradient is 1000°C/mm - 2000°C/mm.

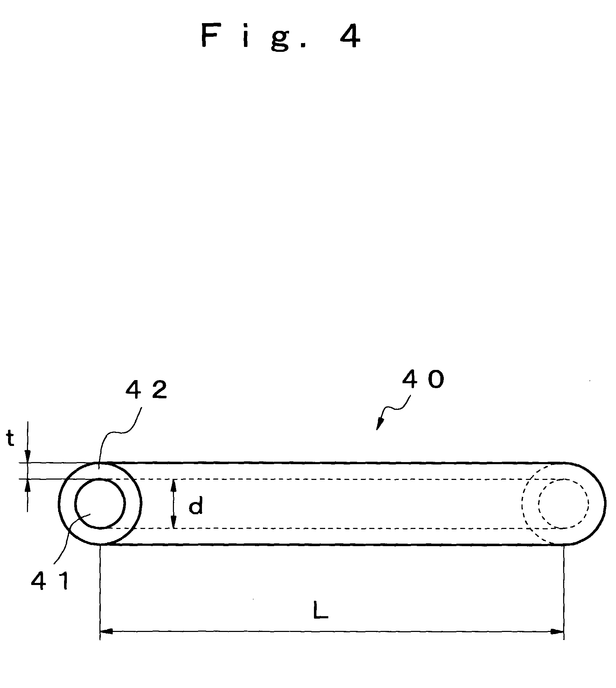

The LPE method comprises soaking a base non-superconducting fiber in a molten liquid of an oxide to be the superconducting oxide to allow liquid phase epitaxial growth, and subjecting the fiber to an oxygen introduction treatment to form a thick layer of superconducting oxide around the non-superconducting fiber, whereby to produce the thin fiber used in the present invention. Fig. 4 shows one embodiment of the thin fiber to be used in the present invention, which was prepared by LPE method. As shown in the embodiment in Fig. 4, a thick layer 42 of superconducting oxide is formed around the non-superconducting fiber 41. The thin fiber 40 is a complex fiber made of a non-superconductor and a superconducting oxide.

When preparing a complex fiber as shown in Fig. 4 by the LPE method, the selection of non-superconducting fiber to be the base is critical. In the present invention, a fiber made of single crystal YSZ, single crystal STO, single crystal MgO, polycrystal YSZ, polycrystal STO, polycrystal MgO, single crystal ZrO, polycrystal ZrO, single crystal BaZrO, polycrystal BaZrO and the like can be used. Of these, a fiber made of single crystal YSZ, single crystal STO or single crystal MgO is preferably used from the aspect of suppression of reactivity between molten liquid and a base when the base is soaked in the molten liquid and the degree of inplane orientation of the superconducting layer formed.

As mentioned above, the heat load when a copper wire is used as a lead wire includes Joule's heat generated in a copper wire and an invasion heat transmitted through a copper wire. For example, when a 25 mA direct current is flown through a typical copper wire (diameter 30 μm, length 10 cm) (electric resistivity of copper :$0.1\times10^{-8}$ Ωm), the heat load is approximately $574\times10^{-6}$ W. In contrast, in the case of thin fibers shown in Fig. 3 and Fig. 4, the heat load due to Joule's heat can be ignored. The heat load P of the thin fiber shown in Fig. 3 is expressed by the following formula 1, wherein S is a cross sectional area of a thin fiber, L is a length of the thin fiber, $T_1$ is a temperature on the low temperature side of the current lead, $T_2$ is a temperature on the high temperature side of the current lead, and λ is a heat conductivity.

**Formula 1**

$$P = \frac{S}{L} \int_{T_1}^{T_2} \lambda \, dT$$

The heat load P of the thin fiber shown in Fig. 4 is expressed by the following formula 2, wherein t is a film thickness of the superconductor, L is a length of thin fiber, d is a diameter of a non-superconducting fiber, $T_1$ is a temperature on the low temperature side of the current lead, $T_2$ is a temperature on the high temperature side of the current lead, and λ is a heat conductivity.

**Formula 2**

$$P = \frac{\pi dt + \pi t^2}{L} \int_{T_1}^{T_2} \lambda \, dT$$

Therefore, when the length L of the thin fiber in formula 1 is, for example, 10 cm, and the diameter D of the thin fiber is about not more than 250 μm (cross sectional area S of thin fiber being not more than 0.049 mm$^2$), the heat load is preferably near equivalent to that of the aforementioned copper wire. When the diameter D is not more than 100 μm, the heat load is not more than 1/8 of the aforementioned copper wire, which is more preferable. The lower limit of the diameter D is not particularly set, but it is preferably 50 μm.

In the formula 2, when the length L of the thin fiber is 10 cm, the diameter of the non-superconducting fiber is 500 μm and the film thickness t of the superconductor is not more than 30 μm, the heat load is preferably near equivalent to that of the aforementioned copper wire. When the film thickness t is 10 μm, the heat load is about 1/3 of the aforementioned copper wire, which is more preferable. The lower limit of the film thickness t is not particularly limited, but it is preferably 5 μm.

The thin fiber to be used in the present invention can thus reduce the heat load as compared to conventional copper wires.

The electronic device constituting the superconducting system of the present invention is not particularly limited as long as it is made of a superconductor. The kind of the superconductor to be used for the electronic device is not particularly limited and exemplified by superconducting oxide, metallic superconductor (e.g., NbTi) and the like, while the number of channels in the electronic device is not particularly limited, a greater number of channels means greater effect afforded by the present invention.

Specific examples of the electronic device include systems utilizing SQUID, such as fruit sugar content detection system, biological magnetism detection system and the like, SQUID systems to detect quantized magnetic flux such as MEG, various circuits or computer systems utilizing Josephson element, Josephson sampler, microwave filtering system for transmission and reception, and the like.

The superconducting system of the present invention needs to be cooled, as shown in Fig. 1. For this end, liquid helium and liquid nitrogen may be used as shown in Fig. 1, or a freezer may be used. The freezer may be, but is not particularly limited to, a conventional two step freezer.

The switchboard to be used in the present invention is not particularly limited as long as it can electrically connect a thin fiber and a normal conductor fiber, as shown in Fig. 1. A preferable mode of the switchboard is a mechanism capable of connection between a thin fiber and a normal conductor fiber, such as one additionally comprising a switch mechanism consisting of a semiconductor switching element or a superconductor switching element.

The external device to which the superconducting system of the present invention is connected may be, for example, a power source to supply current to an electronic device, wherein the kind of power source is not particularly limited. For example, when the electronic device is a computer system utilizing Josephson element, a pulse is supplied from a commercial power source via a transformer and a regulator.

The present invention is explained in more detail in the following by way of Examples, to which the present invention is not limited.

The thin fibers shown in Figs. 3, 4 were prepared and the superconducting system of the present invention was completed.

**Example 1**

Preparation of thin fiber

Using the apparatus shown in Fig. 2, a thin fiber as shown in Fig. 3 was prepared by unidirectional solidification. As the laser beam oscillator, a carbonic acid gas laser beam (maximum output 35W) was used and the beam was controlled to make the beam output from the attenuation apparatus not more than 1 W. The sample was Sm-Ba-Cu superconducting oxide. The inside of the chamber was set to a low oxygen atmosphere of 0.01 atm partial oxygen pressure.

Then, the temperature gradient of the molten-solidification interface was set to 1200°C/mm - 1500°C/mm, and the rate of pulling out of the samples (speed of molten-solidification interface) was set to 24 mm/h, and the sample was irradiated with a laser beam, which was followed by an oxygen introduction treatment, to give a single crystal thin fiber having a diameter of 150 $\mu$m and a length of 10 cm.

Terminals were connected to this thin fiber at 1 cm intervals, and the fiber was immersed in liquid nitrogen, and critical current density was calculated by a direct current four terminal method comprising flowing a direct current and determining the point, where a 1 $\mu$V/cm voltage occurs, as a critical current density capable of flowing a superconducting current. As a result, critical current density was $10^4$ A/cm$^2$.

Construction of superconducting system

Using the thin fiber obtained above, the superconducting system of the present invention was completed. As the electronic device, used was Rapid Single Flux Quantum Logic Circuit (RSFQ logic circuit) utilizing Josephson element. This electronic device had 10 channels. Eleven (bias 10, GND 1) thin fibers commensurate in number with the channels were prepared. As the switchboard, one equipped with a switch mechanism consisting of semiconductor switching element was used. As the normal conductor fiber to connect the switchboard and the external device, an enameled copper wire having an outer diameter of 30 $\mu$m was used. The superconducting system was cooled with liquid helium and liquid nitrogen. Then, the system was operated, and the heat load was calculated from the amount of evaporated liquid helium, which was found to be 3 mW.

**Example 2**

Preparation of thin fiber

According to LPE, a thin fiber as shown in Fig. 4 was prepared. First, a mixture of Y$_2$Ba$_1$CuO$_x$ powder and Ba$_3$CuSOx powder in a weight ratio of 2:8 was packed in a crucible made of yttrium polycrystals and melted therein. After melting, the temperature at the surface of the liquid was set to not more than peritectic temperature (about 1005°C) of Y$_1$Ba$_2$Cu$_3$O$_x$, so that Y$_1$Ba$_2$Cu$_3$O$_x$ could be formed, and the liquid was maintained in the state of a supercooled molten liquid. Then, an MgO single crystal fiber having a seed film (Sm$_1$Ba$_2$Cu$_3$O$_x$) attached to the surface by plasma deposition was soaked in the molten liquid for 5 mm to allow liquid phase epitaxial growth of 10 $\mu$m thick Y$_1$Ba$_2$Cu$_3$O$_x$ single crystal on the seed film, which was subjected to an oxygen introduction treatment to complete the thin fiber as shown in Fig. 4. The critical current density of this thin fiber was calculated in the same manner as in Example 1 and found to be $10^6$ A/cm$^2$.

Construction of superconducting system

Using the thin fiber obtained above, the superconducting system of the present invention was completed. As the electronic device, used was RSFQ logic circuit utilizing Josephson element, which had 10 channels. Eleven (bias 10, GND 1) thin fibers commensurate in number with the channels were prepared. As the switchboard, one equipped with a switch mechanism consisting of semiconductor switching element was used. As the normal conductor fiber to connect the switchboard and the external device, an enameled copper wire having an outer diameter of 30 μm was used. The superconducting system was cooled with liquid helium and liquid nitrogen. Then, the system was operated, and the heat load was calculated from the amount of evaporated liquid helium, which was found to be 2.5 mW.

## Example 3

Preparation of thin fiber

According to LPE, a thin fiber as shown in Fig. 4 was prepared. First, a mixture of $Sm_2Ba_1Cu_1O_x$ powder and $Ba_3CuSO_x$ powder in a weight ratio of 2:8 was packed in a crucible made of samarium polycrystals and melted therein. After melting, the temperature at the surface of the liquid was set to not more than peritectic temperature (about 1020°C) of $Sm_1Ba_2Cu_3O_x$, so that $Sm_1Ba_2Cu_3O_x$ could be formed, and the liquid was maintained in the state of a supercooled molten liquid. Then, an MgO single crystal fiber having a seed film ($Sm_1Ba_2Cu_3O_x$) attached to the surface by plasma deposition was soaked in the molten liquid for 5 min to allow liquid phase epitaxial growth of 10 μm thick $Sm_1Ba_2Cu_3O_x$ single crystal on the seed film, which was subjected to an oxygen introduction treatment. Then, a terminal was connected to this complex fiber at 1 cm intervals between voltage terminals, to complete the thin fiber. The critical current density was calculated in the same manner as in Example 1 and found to be $1.5 \times 10^6$ A/cm$^2$.

Construction of superconducting system

Using the thin fiber obtained above, the superconducting system of the present invention was completed. As the electronic device, used was RSFQ logic circuit utilizing Josephson element, which had 10 channels. Eleven (bias 10, GND 1) thin fibers commensurate in number with the channels were prepared. As the switchboard, one equipped with a switch mechanism consisting of semiconductor switching element was used. As the normal conductor fiber to connect the switchboard and the external device, an enameled copper wire having an outer diameter of 30 μm was used. The superconducting system was cooled with liquid helium and liquid nitrogen. Then, the system was operated, and the heat load was calculated from the amount of evaporated liquid helium, which was found to be 2.6 mW.

## Comparative Example

In the superconducting system prepared in Example 1, an enameled copper wire having a diameter of 30 μm was used instead of the thin fiber made of superconducting oxide to constitute the system. The system was operated, and the heat load was calculated, which was found to be 7 mW.

From the above-mentioned Examples and Comparative Example, it has been confirmed that, in the superconducting system of the present invention, the heat load can be suppressed as compared to conventional superconducting systems.

As explained in the foregoing, the superconducting system of the present invention uses a thin fiber made of superconducting oxide as a lead wire, thereby to suppress the heat load. Therefore, the superconducting system of the present invention can realize reduction of the load on a freezer used to cool an electronic device or reduction of the amount of evaporated solvent. It is also capable of coping with the multi-channeling of an electronic device in the future.

## Claims

1. A superconducting system comprising an electronic device using a superconductor and a thin fiber made of superconducting oxide to electrically connect the electronic device to an external device.

2. The superconducting system of claim 1, wherein the thin fiber is a single crystal fiber prepared by unidirectional solidification.

3. The superconducting system of claim 2, wherein the thin fiber has a diameter of not more than 500 μm.

4. The superconducting system of claim 1, wherein the thin fiber comprises a non-superconducting fiber and a layer of superconducting oxide formed thereon.

5. The superconducting system of claim 4, wherein the superconducting oxide layer has a thickness of not more than 100 μm.

6. The superconducting system of claim 1, wherein the superconducting oxide is rare earth superconducting oxide.

7. The superconducting system of claim 1, wherein the electronic device is a SQUID system to detect quantized flux or a computer system utilizing a Josephson element.

**EP 1 001 473 A2**

**8.** The superconducting system of claim 1, further comprising a switchboard and a normal conductor fiber, wherein the thin fiber is electrically connected to an external device via the switchboard and then the normal conductor fiber.

# Fig. 1

# Fig. 2

# Fig. 3

31

D

L

# F i g .  4